# EUROPEAN PATENT APPLICATION

(11) **EP 2 400 545 A2**
(43) Date of publication of application: **28.12.2011**
(21) Application number: 11005016.8
(22) Date of filing: 20.06.2011
(51) Int. Cl.: H01L 23/48, H01L 23/522

(54) **Package for a wireless enabled integrated circuit**

(30) Priority: 23.06.2010 US 357880 P; 07.02.2011 US 22277
(71) Applicant: Broadcom Corporation, Irvine, CA 92617 (US)
(72) Inventor: Zhao, Sam Ziquin, 92618 Irvine, CA (US); Rofougaran, Ahmadreza, 92657 Newport Coast, CA (US); Behzad, Arya, 92064 Poway, CA (US); Castaneda, Jesus, 90066 Los Angeles, CA (US); Boers, Michael, 92618 Irvine, CA (US)
(74) Representative: Jehle, Volker Armin

(57) **Abstract**

An integrated circuit (IC) device is provided. The IC device includes a substrate, an IC die coupled to the substrate, and a first wirelessly enabled functional block formed on the IC die. The first wirelessly enabled functional block is configured to wirelessly communicate with a second wirelessly enabled functional block formed on the substrate.

## Description

### CROSS REFERENCE TO RELATED APPLICATIONS

This application claims the benefit of U.S. Provisional Appl. No. 61/357,880, filed June 23, 2010, which is incorporated by reference herein in its entirety.

### BACKGROUND OF THE INVENTION

### Field of the Invention

The present invention generally relates to integrated circuit (IC) devices, and more particularly to connections between elements of an IC device.

### Background Art

Integrated circuit (IC) devices typically include an IC die housed in a package. The 1C device can be coupled to a printed circuit board (PCB) to enable communication between the 1C device and other devices coupled to the PCB. For example, in array-type packages, an IC die is often coupled to a substrate, which is coupled to an array of connection elements, e.g., an array of solder balls. The array of connections elements is then physically coupled to the PCB.

An IC die can be coupled to a substrate in a variety of ways. For example, in diedown flip-chip packages, solder bumps can be used to couple contact pads on a surface of the IC die to the substrate. In another example, wirebonds can be used to couple bond pads on a surface of the IC die to bond fingers located on the substrate.

Conventional ways of coupling an IC die to a substrate can, however, be costly. For example, the materials used to create wirebonds, e.g., gold, can be expensive, thus increasing the cost of the entire device. Furthermore, the conventional ways of coupling the IC die to the substrate can also be susceptible to manufacturing defects. For example, wirebonds and/or solder bumps can break or be damaged during the manufacturing process, reducing the throughput for the IC device.

What is needed is an IC device that provides for cost-effective and reliable interconnections between an 1C die and a substrate.

### BRIEF SUMMARY OF THE INVENTION

In embodiments described herein, integrated circuit (IC) devices are provided. In one embodiment, The IC device includes a substrate, an IC die coupled to the substrate, a signal plane coupled to the IC die, and a first wirelessly enabled functional block formed on the IC die. The first wirelessly enabled functional block is configured to wirelessly communicate with a second wirelessly enabled functional block formed on the substrate. The IC die includes a via that electrically couples the signal plane to the wirelessly enabled functional block.

In another embodiment, a method of manufacturing an IC device includes providing an IC die, forming a via through the IC die, forming a first wirelessly enabled functional block on the 1C die, coupling a signal plane to the IC die, and coupling the IC die to a substrate. The via couples the first wirelessly enabled functional block to the signal plane. The first wirelessly enabled functional block is configured to wirelessly communicate with a second wirelessly enabled functional block coupled to the substrate. According to an aspect of the invention, an integrated circuit (IC) device comprises:
a substrate;
an IC die coupled to the substrate; and
a first wirelessly enabled functional block formed on the 1C die, wherein the first wirelessly enabled functional block is configured to wirelessly communicate with a second wirelessly enabled functional block formed on the substrate.
Advantageously, the IC device further comprises a signal plane coupled to the IC die.
Advantageously, the signal plane comprises at least one of: a power portion and a ground portion.
Advantageously, the IC die has opposing first and second surfaces, wherein the substrate is coupled to the first surface of the IC die, wherein the first wirelessly enabled functional block is coupled to the first surface of the IC die, and wherein the signal plane is coupled to the second surface of the IC die.
Advantageously, the IC die comprises a via that electrically couples the signal plane to the first wirelessly enabled functional block.
Advantageously, the signal plane is configured so as to have an opening to facilitate communication between the first wirelessly enabled functional block and the second wirelessly enabled functional block.
Advantageously, at least one of the first wirelessly enabled functional block and the second wirelessly enabled functional block comprises a circuit trace or a metal island.
Advantageously, at least one of the first wirelessly enabled functional block and the second wirelessly enabled functional block comprises an antenna.
Advantageously, the antenna is a dipole antenna or a patch antenna.
Advantageously, at least one of the first wirelessly enabled functional block and the second wirelessly enabled functional block comprises a transceiver.
Advantageously, the IC device further comprises a heat spreader coupled to the second surface of the IC die.
Advantageously, the heat spreader is coupled to the substrate.
Advantageously, the IC device further comprises a solder bump coupled to the first surface of the IC die and the substrate.
Advantageously, the IC die includes at least one embedded metal layer.
According to an aspect, a method of manufacturing an integrated circuit (IC) device comprises:
providing an IC die;
forming a first wirelessly enabled functional block on the IC die;
coupling the 1C die to a substrate, wherein the first wirelessly enabled functional block is configured to wirelessly communicate with a second wirelessly enabled functional block coupled to the substrate.
Advantageously, the forming the first wirelessly enabled functional block comprises forming a circuit trace.
Advantageously, the forming the first wirelessly enabled functional block comprises coupling a transceiver to the IC die.
Advantageously, the method further comprises:
coupling a signal plane to the IC die.
Advantageously, the method further comprises:
forming a via through the IC die, wherein the via couples the first wirelessly enabled functional block to the signal plane.
Advantageously, the 1C die has opposing first and second surfaces, wherein the substrate is coupled to the first surface of the IC die, wherein the first wirelessly enabled functional block is coupled to the first surface of the IC die, and wherein the signal plane is coupled to the second surface of the IC die, further comprising:
coupling a heat spreader to the second surface of the IC die.
Advantageously, the IC die has opposing first and second surfaces, wherein the substrate is coupled to the first surface of the IC die, wherein the first wirelessly enabled functional block is coupled to the first surface of the IC die, and wherein the signal plane is coupled to the second surface of the IC die, further comprising:
coupling a solder bump to the first surface of the IC die and the substrate.
Advantageously, the IC die has opposing first and second surfaces, wherein the substrate is coupled to the first surface of the IC die, wherein the first wirelessly enabled functional block is coupled to the second surface of the IC die, and wherein the signal plane is coupled to the first surface of the IC die.
Advantageously, the method further comprises:
forming an opening in the signal plane, the opening configured to facilitate communication between the first wirelessly enabled functional block and the second wirelessly enabled functional block.

These and other advantages and features will become readily apparent in view of the following detailed description of the invention. Note that the Summary and Abstract sections may set forth one or more, but not all exemplary embodiments of the present invention as contemplated by the inventor(s).

### BRIEF DESCRIPTION OF THE DRAWINGS/FIGURES

The accompanying drawings, which are incorporated herein and form a part of the specification, illustrate the present invention and, together with the description, further serve to explain the principles of the invention and to enable a person skilled in the pertinent art to make and use the invention.

FIG. 1 cross-sectional view of a conventional die down ball grid array (BGA) package.

FIG. 2A shows a cross-sectional view of a die down IC device, according to an embodiment of the present invention.

FIG. 2B shows a cross-sectional view of a die down IC device, according to an embodiment of the present invention.

FIG. 3 shows diagram of a wirelessly enabled functional block, according to an embodiment of the present invention.

FIG. 4 shows a cross-sectional view of die down IC device, according to an embodiment of the present invention.

FIGS. 5-7 show cross-sectional views of die up IC devices, according embodiments of the present invention.

FIGS. 8-9 show top views of signal planes, according embodiments of the present invention.

FIGS. 10-11 show flowcharts providing example steps for assembling IC devices, according to embodiments of the present invention

The present invention will now be described with reference to the accompanying drawings. In the drawings, like reference numbers indicate identical or functionally similar elements. Additionally, the left-most digit(s) of a reference number identifies the drawing in which the reference number first appears.

### DETAILED DESCRIPTION OF THE INVENTION

References in the specification to "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

Furthermore, it should be understood that spatial descriptions (e.g., "above", "below", "left," "right," "up", "down", "top", "bottom", etc.) used herein are for purposes of illustration only, and that practical implementations of the structures described herein can be spatially arranged in any orientation or manner.

### Conventional Packages

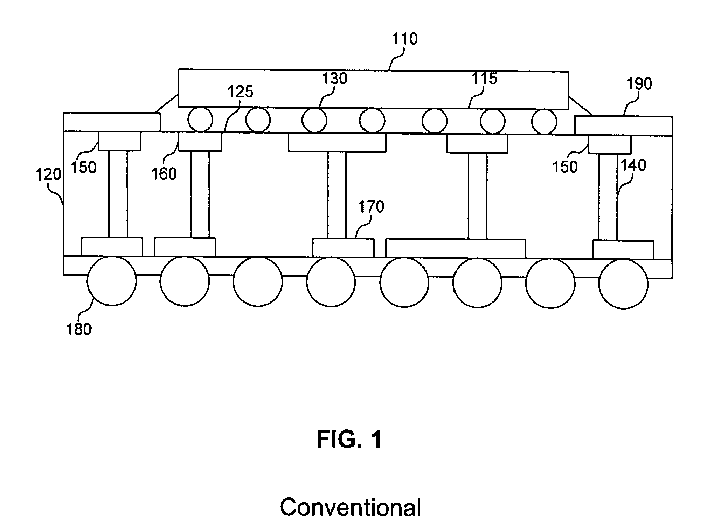

FIG. 1 shows a cross-sectional view of a conventional die down ball grid array (BGA) package 100. BGA package 100 includes a die 110 coupled to a top surface 125 of a substrate 120 via solder bumps 130. BGA package 100 is a die down package in which an active surface 115 of die 110 faces substrate 120. On the other hand, in die up packages, the active surface of the die faces away from the substrate.

Active surface 115 often includes power and ground distribution rails and input/output contact pads. A plurality of solder bumps 130 can be distributed across active surface 115 of flip chip die 110 to respectively connect flip chip die 110 to substrate 120. As shown in FIG. 1, a solder mask 190 surrounds the area where solder bumps 130 are located.

In the embodiment of FIG. 1, vias 140 connect solder bumps 130, traces, and/or via pads 150 at top surface 125 of substrate 120 to solder balls 180 at a bottom surface of substrate 120. As shown in FIG. 1, substrate 120 can include bump pads 160 and ball pads 170. Bump pads 160 are connected to solder bumps 130 at top surface 125 of substrate 120. Ball pads 170 are connected to solder balls 180 at the bottom surface of substrate 120. Solder balls 180 can electrically connect flip chip BGA package 100 to any suitable surface having electrically conductive connections, such as a PCB.

### Exemplary Embodiments

According to embodiments described herein, IC devices include an IC die having wirelessly enabled functional blocks that communicate with wirelessly enabled functional blocks formed on a substrate. Advantages of these packages include a streamlined manufacturing process, increased flexibility in forming interconnections, improved throughput, and decreased yield loss.

Conventional ways of coupling an IC die to a substrate require at least one additional step in the manufacturing process to form the interconnections. For example, additional steps may be needed form wire bonds or solder bumps for flip chip interconnections. In contrast, the formation of wirelessly enabled functional blocks according to embodiments described herein can be incorporated in other steps of the manufacturing process, e.g., during the formation of the IC die and/or the formation of the substrate. Moreover, IC devices described herein can also have higher throughput than conventional devices because additional machinery needed to create conventional interconnections may not be needed.

Furthermore, conventional interconnections often require a rigid interconnection layouts in which paths for any two interconnections cannot cross. In contrast, communications using wirelessly enabled functional blocks do not involve a physical interconnection between the IC die and the substrate. Thus, communication paths can cross without undesired effects.

IC devices described herein can also have decreased yield loss compared to conventional IC devices because conventional interconnections can be damaged during manufacturing. Wirelessly enabled functional blocks accordingly to embodiments described herein can be less likely to be damaged during manufacturing.

In other embodiments, wirelessly enabled functional blocks also include a transceiver that performs signal conditioning operations and feeds an antenna. The 1C devices can also include a signal plane that can be coupled to the wirelessly enabled functional blocks formed on the IC die. In an embodiment, the signal plane provides a ground voltage to the wirelessly enabled functional blocks.

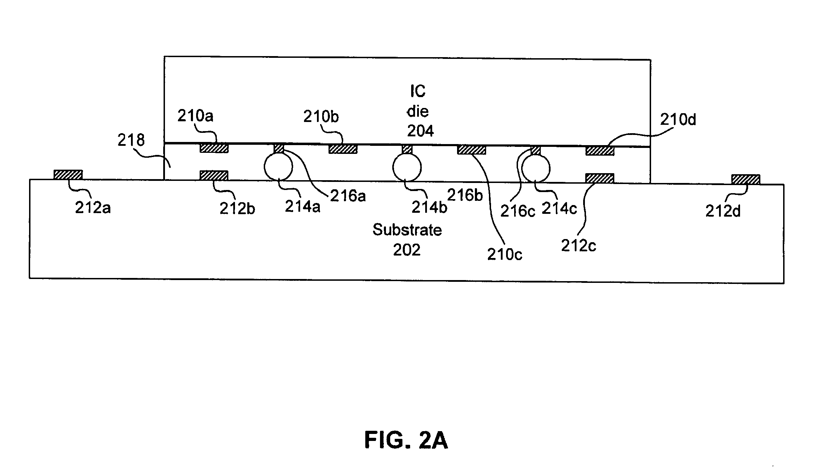

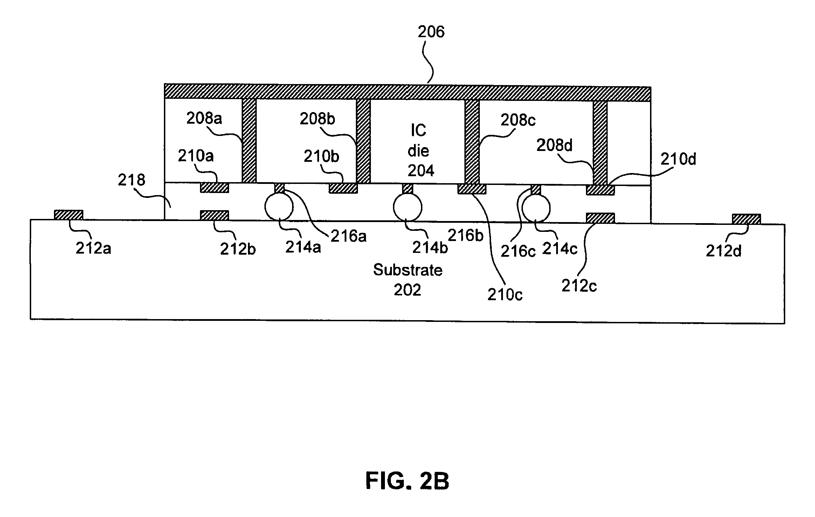

FIGS. 2A and 2B show cross-sectional views of die down IC devices 200 and 250, respectively, according to embodiments of the present invention. IC device 200 includes a substrate 202, an IC die 204, wirelessly enabled functional blocks 210a, 210b, 210c, and 210d (collectively "210"), wirelessly enabled functional blocks 212a, 212b, 212c, and 212d (collectively "212"), solder bumps 214a, 214b, and 214c (collectively "214"), contact pads 216a, 216b, and 216c (collectively "216"), and an adhesive 218.

An adhesive 218 couples IC die 204 to substrate 202. In an embodiment, adhesive 218 can be an epoxy. In other emobdiment, adhesive 218 can be an underfill, epoxy underfill, or a molding compound.

In this embodiment, substrate 202 is substantially similar to substrate 120 described with reference to FIG. 1. Although not shown in FIG. 2, substrate 202 can be coupled to an array of elements that are configured to be coupled to a PCB. The array of elements can include any of solder balls (as in a ball grid array package), pads (as in a land grid array package), and pins (as in a pin grid array packages).

IC device 250 is similar to IC device 200 except that IC device 250 additionally includes a signal plane 206 and through silicon vias 208a, 208b, 208c, and 208d (collectively "208"). In an embodiment, signal plane 206 includes a single portion having a single voltage (e.g., ground). In another embodiment, signal plane 206 can include multiple portions that are electrically insulated from each other. In such an embodiment, each portion can have its own voltage (e.g., potentials can include ground and different power voltages).

Vias 208 couple wirelessly enabled functional blocks 210 to signal plane 206. For example, vias 208 can couple wirelessly enabled functional blocks 210 to a portion of signal plane 206 that has a ground potential. As shown in FIG. 2, coupling wirelessly enabled functional blocks 210 to ground plane 206 using vias 208 can be indirect or direct. For example, vias 208c and 208d directly couple wirelessly enabled functional blocks 210c and 210d, respectively, to signal plane 206. On the other hand, via 208a indirectly couples wirelessly enabled functional block 210a to signal plane 206. Specifically, as shown in FIG. 2, via 208a extends to the bottom surface of IC die 204. A trace (not shown) couples via 208a to wirelessly enabled functional block 210a.

In other embodiments, vias 208 can include vias that do not extend all the way through IC die 204. In such an embodiment, multiple vias could be used to couple a wirelessly enabled functional block to a signal plane. For example, in an IC die that has embedded metal layer(s), multiple vias can be used to couple wirelessly enabled functional blocks to a signal plane. Such embedded metal layer(s) can be formed, for example, using a silicon on insulator (SOI) process in which layer(s) can be formed within an IC die.

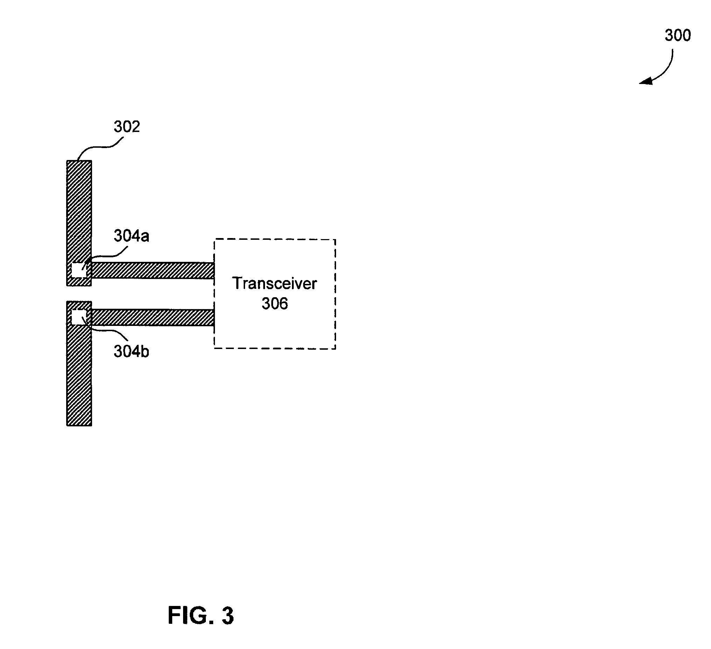

Wirelessly enabled functional blocks 210 and 212 enable IC die 204 to send signals to and receive signals from substrate 202. In an embodiment, wirelessly enabled functional blocks 210 and 212 serve to replace solder bumps that would be otherwise used to couple IC die 204 to substrate 202. The structure of wirelessly enabled functional blocks 210 and 212 will be described with reference to FIG. 3.

In an embodiment, any of wirelessly enabled functional blocks 210 can be configured to communicate with any of wirelessly enabled functional blocks 212. For example, wirelessly enabled functional block 210a can be configured to communicate with wirelessly enabled functional blocks 212 (i.e., the closest wirelessly enabled functional block coupled to the substrate) or any other wirelessly enabled functional block 212, such as wirelessly enabled functional block 212a. In an embodiment, wirelessly enabled functional blocks 210 and 212 can employ a frequency, a time, or a code division method so that communications between one pair of wirelessly enabled functional blocks do not interfere with communications between another pair of wirelessly enabled functional blocks.

As shown in FIG. 2, package 200 also includes solder bumps 214 coupled to respective contact pads 216 formed on the surface of IC die 204. Thus, IC die 204 is able to send signals to and receive signals from substrate 202 through both wirelessly enabled functional blocks 210 and 212 and solder bumps 214. In another embodiment, package 200 does not include solder bumps 214. In such an embodiment, wirelessly enabled functional blocks 210 and 212 are used for all communications between IC die 204 and substrate 202.

FIG. 3 shows diagram of a wirelessly enabled functional block 300, according to an embodiment of the present invention. Wirelessly enabled functional block 300 includes an antenna 302. Wirelessly enabled functional blocks 210 and/or 212 can be implemented in a manner substantially similar to wirelessly enabled functional block 300.

As shown in FIG. 3, antenna 302 is a dipole antenna. Other antenna configurations can be used as appropriate. In an embodiment, antenna 302 can be formed out of metal traces or planes. For example, dipole antenna 302 can be formed using traces on the bottom surface of IC die 204 or on the top surface of substrate 202. Antenna 302 can be configured to operate in a certain frequency range (e.g., by adjusting the dimensions of antenna 302). In other embodiments, antenna 302 can be another type of antenna. For example, antenna 302 can be a patch antenna having a square or rectangular shape.

In an embodiment, through silicon vias 304A and 304B (collectively "304") feed antenna 302. Specifically, via 304a can be coupled to a signal plane. For example, via 304a can be coupled to a signal plane of an IC die, e.g., signal plane 206. When wirelessly enabled functional block 300 is formed on a substrate, via 304a can be coupled to a signal plane of the substrate, e.g., a ground plane of the substrate. Via 304b can be coupled to circuit block of an IC die or a portion of substrate 202 from which a signal from a PCB is received.

As shown in FIG. 3, wirelessly enabled functional block optionally includes a transceiver 306. In such an embodiment, antenna 302 is fed by transceiver 306. Transceiver 306 can be coupled to a signal plane using vias of a die or substrate. In an embodiment, tranceiver 306 is also coupled to a circuit block or a portion of a PCB (e.g., through a substrate). Tranceiver 306 can be configured to transmit signals received from the circuit block or the PCB and/or convey received signals to the circuit block or the PCB. In a further embodiment, transceiver 306 can have additional functionality. For example, transceiver 306 may be capable of performing signal processing tasks such as modulation.

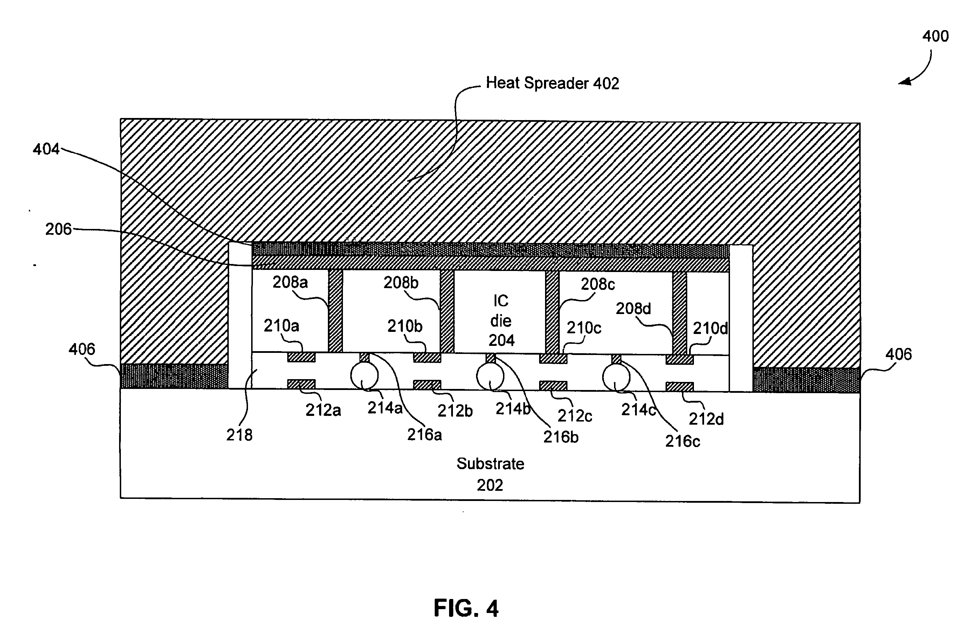

FIG. 4 shows a cross-sectional view of a die down IC device 400, according to an embodiment of the present invention. IC device 400 is substantially similar to IC device 200 shown in FIG. 2 except that IC device 400 additionally includes a heat spreader 402. Heat spreader 402 is coupled to IC die 204 through an adhesive 404. Additionally, it can also be coupled to substrate 202 through an adhesive 406. Adhesives 404 and 406 can be thermally conductive so that heat can be spread from IC die 204 to substrate 202. In a further embodiment, adhesives 404 and 406 can be electrically conductive. For example, signal plane 206 may be made up of single portion that is grounded. Heat spreader 402, then, acts as a Faraday cage shielding IC die 204 from external radiation interference and enhancing communications between wirelessly enabled functional blocks 210 and 212.

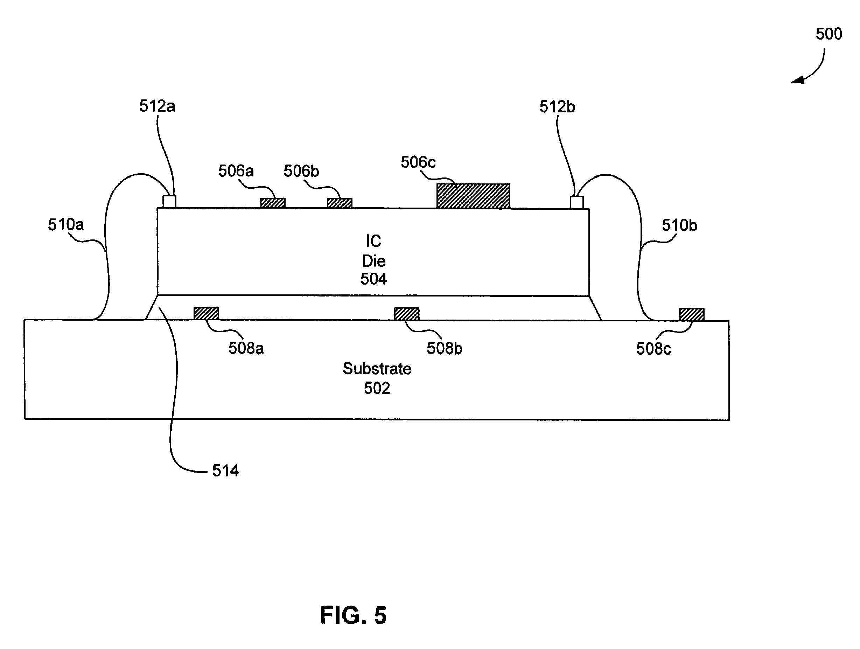

FIG. 5 shows a cross-sectional view of a die up IC device 500, according to an embodiment of the present invention. IC device 500 includes a substrate 502, an IC die 504, wirelessly enabled functional blocks 506a, 506b, and 506c (collectively "506"), wirelessly enabled functional blocks 508a, 508b, and 508c (collectively "508"), wirebonds 510a and 510a (collectively "510"), bond pads 512a and 512b (collectively "512"), and an adhesive 514.

IC die 504 is coupled to substrate 502 through adhesive 514. In an embodiment, substrate 502 is similar to substrate 120. IC die 504 can be similar to IC die 110 except that IC die 504 is implemented in a die up configuration, where the top surface of IC die 504 is the active surface. In an embodiment, the active surface of IC die 504 can be the surface that contains containing layers that include integrated circuits.

Wirelessly enabled functional blocks 506 and 508 enable IC die 504 to wirelessly communicate with substrate 502. In an embodiment, wirelessly enabled functional blocks 506 and 508 are implemented similar to wirelessly enabled functional block 300, described with reference to FIG. 3. Any of wirelessly enabled functional blocks 506 can be configured to communicate with any of wirelessly enabled functional blocks 508. As described above, frequency, time, and code division schemes can be used to prevent communications between one pair of wirelessly enabled functional blocks from interfering with communications between another pair of wirelessly enabled functional blocks.

As shown in FIG. 5, wirelessly enabled functional block 506c is larger than wirelessly enabled functional blocks 506a and 506b. In an embodiment, wirelessly enabled functional block 506c has additional functionality compared to wirelessly enabled functional blocks 506a and 506b. For example, wirelessly enabled functional block 506c may have additional signal processing functionality.

IC device 500 also includes wire bonds 510 and bond pads 512. Thus, IC die 504 can communicate with substrate 502 through wirelessly enabled functional blocks 506 and 508 and -through bond pads 512 and wirebonds 510. Wire bonds 510 are coupled to bond fingers formed on substrate 502 (not shown). In alternate embodiments, IC device 500 does not include wire bonds 510 and bond pads 512. In such an embodiment, all communications between substrate 502 and IC die 504 occur using wirelessly enabled functional blocks 506 and 508.

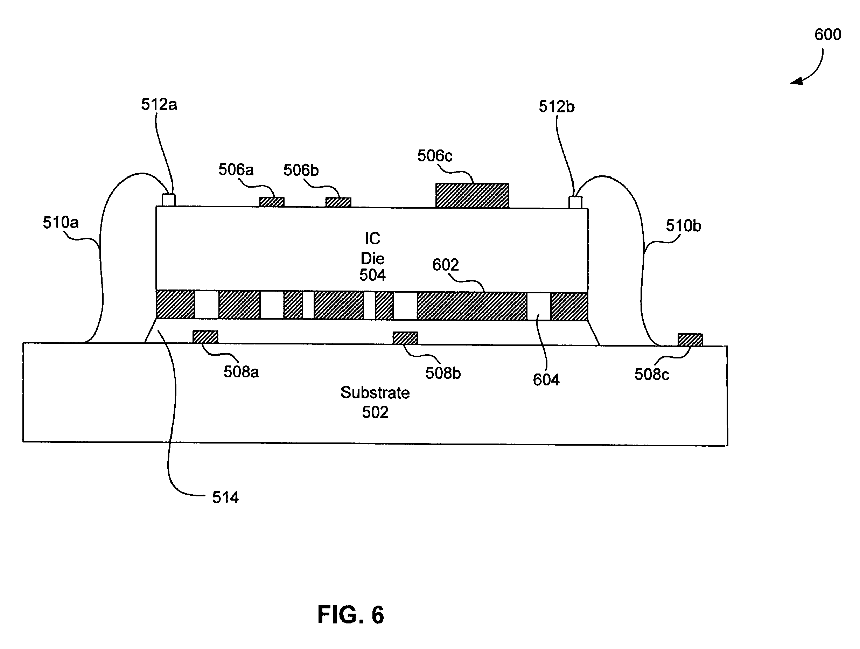

FIG. 6 shows a cross-sectional view of a die up IC device 600, according to an embodiment of the present invention. IC device 600 is substantially similar to IC device 500 shown in FIG. 5, except that IC device 600 additionally includes signal plane 602. Similar to signal plane 206, shown in FIG. 2, signal plane 602 can include a single portion (e.g., a grounded portion) or multiple isolated signal portions having distinct voltages.

As shown in FIG. 6, signal plane 602 includes openings 604. In an embodiment, openings 604 facilitate communications between wirelessly enabled functional blocks 506 and 508. In particular, signal plane 602 is formed out of an electrically conductive material. Thus, without openings 604, signal plane may interfere with communications between wirelessly enabled functional blocks 506 and 508.

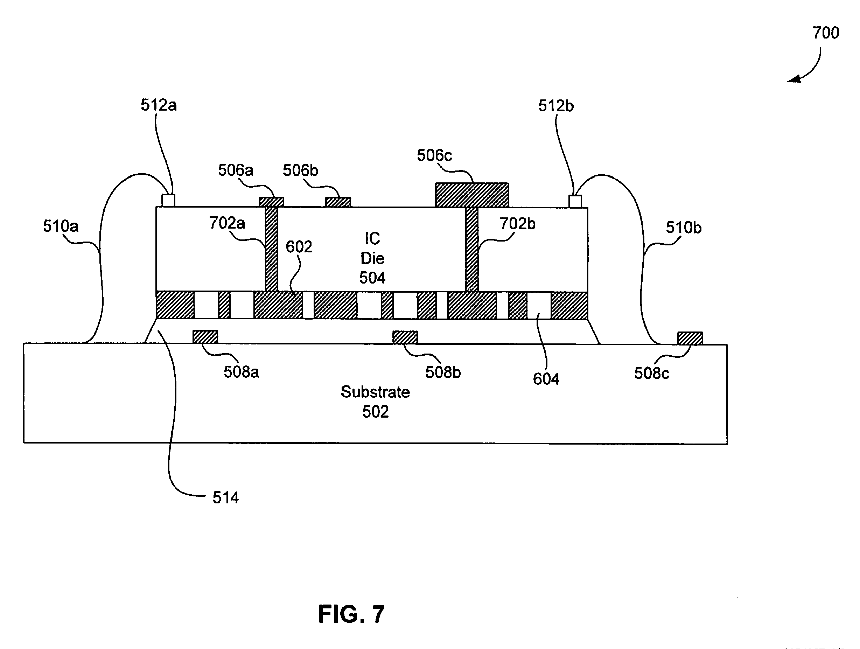

FIG. 7 shows a cross-sectional view of a die up IC device 700, according to an embodiment of the present invention. IC device 700 is substantially similar to IC device 600, shown in FIG. 6 except that IC device 700 additionally includes vias 702a and 702b (collectively "702"). As shown in FIG. 7, vias 702 couple respective blocks of wirelessly enabled functional blocks 506 to signal plane 602. For example, vias 702 can couple respective wirelessly enabled functional blocks 506 to a ground portion of signal plane 602.

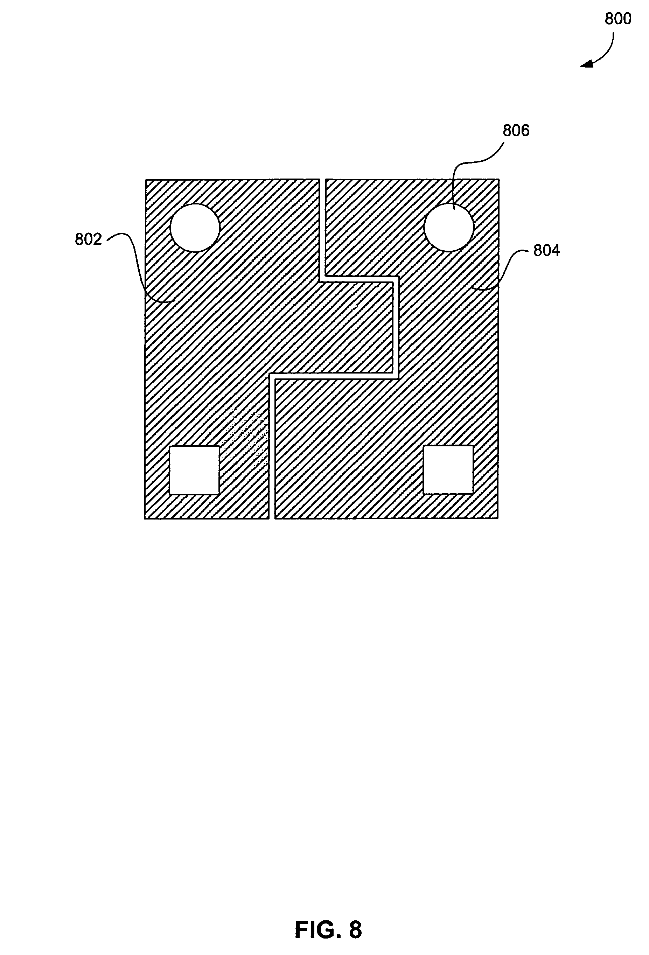

FIG. 8 shows a signal plane 800, according to an embodiment of the present invention. For example, signal plane 800 can be used for signal plane 602 shown in FIGS. 6 and 7. Signal plane 800 includes portions 802 and 804. As shown in FIG. 8, portions 802 and 804 are isolated (e.g., separated) so that they can have different potentials. For example, portion 802 can have a ground potential and portion 804 can have a power potential.

FIG. 8 shows signal plane 800 as including two portions 802 and 804. As would be appreciated by those skilled in the relevant arts based on the description herein, signal plane 800 can include more than two portions. For example, signal plane 800 can include multiple different portions held at different power potentials and a portion that is grounded. In another embodiment, signal plane 800 can include a single portion, e.g., a single portion that is coupled to ground.

As shown in FIG. 8 signal plane 800 includes openings 806. Openings 806 can be used to facilitate communications between wirelessly enabled functional blocks. For example, when signal plane 800 is used in IC device 600, openings 806 can be used to facilitate communications between wirelessly enabled functional blocks 506 and 508. Openings 806 can be in any shape that facilitates the communications between wirelessly enabled functional blocks. FIG. 8 shows signal plane 800 as including four openings. However, as would be appreciated by those skilled in the relevant art based on the description herein, signal plane 800 can include any number of openings 806. In an alternate embodiment, signal plane 800 does not include any openings 806.

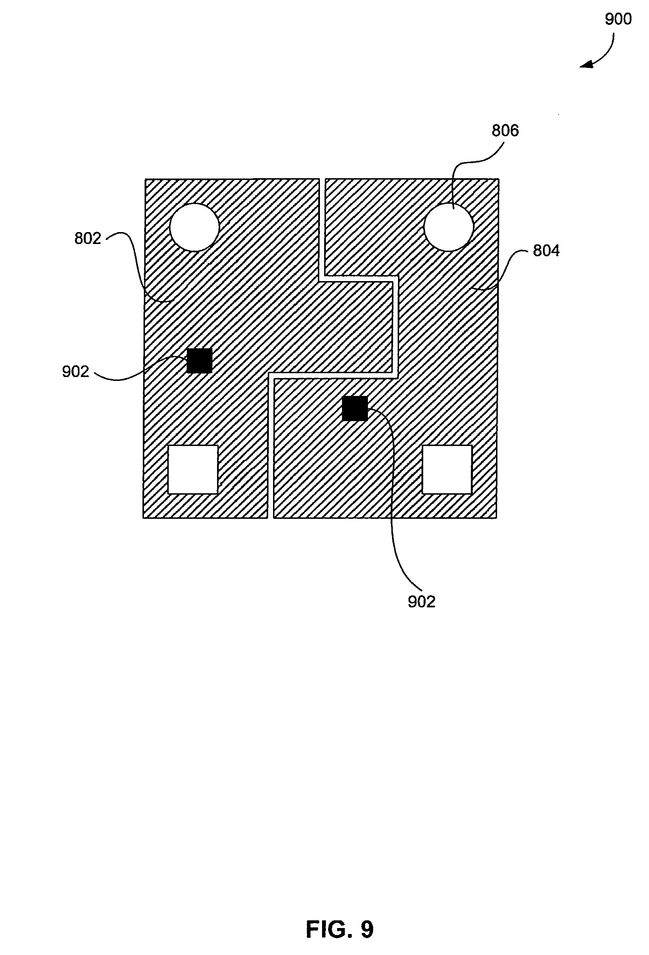

FIG. 9 shows a signal plane 900, according to an embodiment of the present invention. Signal plane 900 is substantially similar to signal plane 800, shown in FIG. 8, except that signal plane 900 additionally includes solder pads 902. In an embodiment, solder pads 902 can be used to receive vias from an IC die, e.g., vias 702 in IC package 700 shown in FIG. 7. In an embodiment, the structure of signal plane 900 can be especially useful when signal plane 900 is implemented as a metallic tape. Such a metallic tape, would be coupled to a surface of an IC die. For example, the metallic tape could be coupled to the bottom surface of IC die 504 in package 700 shown in FIG. 7.

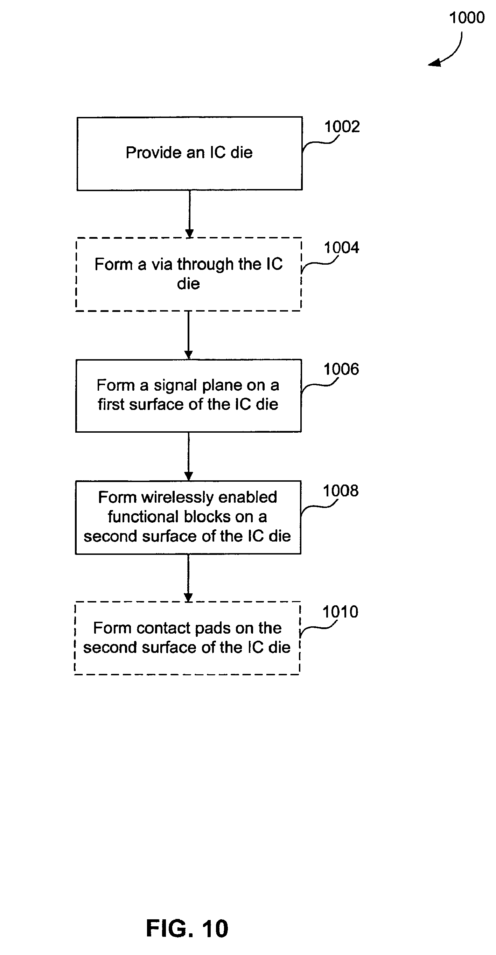

FIG. 10 shows a flowchart 1000 providing example steps for assembling an IC device, according to an embodiment of the present invention. Other structural and operational embodiments will be apparent to persons skilled in the relevant art(s) based on the following discussion. The steps shown in FIG. 10 do not necessarily have to occur in the order shown. The steps of FIG. 10 are described in detail below.

In step 1002, an IC die is provided. For example, IC die 204 shown in FIG. 4 or IC die 504 shown in FIG. 7 can be provided.

In optional step 1004, a via is formed through the IC die. For example, in FIG. 2, vias 208 can be formed through IC die 204. In another example, vias 702 can be formed through IC die 504.

In optional step 1006, a signal plane is formed on a first surface of the IC die. For example, in FIG. 4, signal plane 206 is formed on top surface of IC die 204. In another example, in FIG. 7, signal plane 602 is formed on the bottom surface of IC die 504. In an embodiment, forming a signal plane can include coupling a signal plane to the first surface of the IC die. For example, the signal plane can be a metallic tape that is adhered to the first surface of the IC die. Alternatively, the signal plane can be one or more sheets of metal coupled to the first surface of the IC through an adhesive.

In step 1008, wirelessly enabled functional blocks are formed on a second surface of the IC die. For example, in FIG. 2, wirelessly enabled functional blocks 210 are formed on the bottom surface of IC die 204. In another example, in FIG. 7, wirelessly enabled functional blocks 506 are formed on the top surface of IC die 504. In optional step 1010 contact pads are formed on the second surface of the IC die. For example, in FIG. 4, contact pads 216 are formed on the bottom surface of IC die 204.

In an embodiment, forming the wirelessly enabled functional blocks can include forming one or more traces on the second surface of the IC die. For example, in FIG. 3, antenna 302 can be formed out of one or more traces or metal islands (e.g., a square or rectangular patch antenna). Forming the wirelessly enabled functional block can also include coupling a transceiver to the second surface of the IC die, e.g., transceiver 306 shown in FIG. 3.

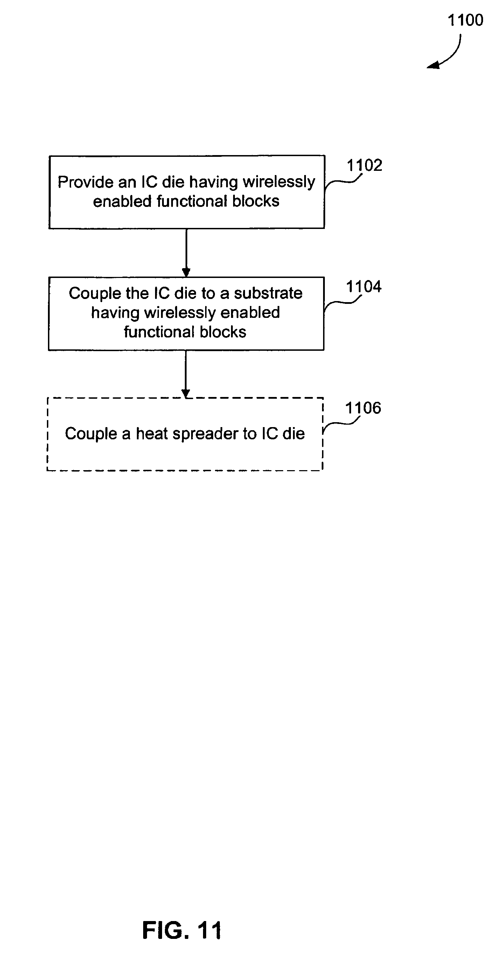

FIG. 11 shows a flowchart 1100 providing example steps for assembling an IC device, according to an embodiment of the present invention. Other structural and operational embodiments will be apparent to persons skilled in the relevant art(s) based on the following discussion. The steps shown in FIG. 11 do not necessarily have to occur in the order shown. The steps of FIG. 1100 are described in detail below.

In step 1102, an IC die having wirelessly enabled functional blocks provided. For example, the IC die resulting from flowchart 1000 can be provided.

In step 1104, the IC die is coupled to a substrate having wirelessly enabled functional blocks. For example, in FIG. 2, IC die 204 is coupled to substrate 202 through an adhesive 218. Furthermore, solder bumps 214 and contact pads 216 serve to electrically couple IC die 204 to substrate 202. In another example, IC die 504 is coupled to substrate 502 through an adhesive 514. Bond pads 512 and wire bonds 510 serve to provide additional electrical coupling between IC die 504 and substrate 502.

In optional step 1106, a heat spreader is coupled to the IC die. For example, in FIG. 4, heat spreader 402 is coupled to IC die 204 through an adhesive 404. Furthermore, heat spreader 402 is coupled to substrate 202 through adhesive 406.

### Conclusion

While various embodiments of the present invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

## Claims

1. An integrated circuit (IC) device, comprising:
a substrate;
an IC die coupled to the substrate; and
a first wirelessly enabled functional block formed on the IC die, wherein the first wirelessly enabled functional block is configured to wirelessly communicate with a second wirelessly enabled functional block formed on the substrate.

2. The IC device of claim 1, further comprising a signal plane coupled to the IC die.

3. The IC device of claim 2, wherein the signal plane comprises at least one of: a power portion and a ground portion.

4. The IC device of claim 2, wherein the IC die has opposing first and second surfaces, wherein the substrate is coupled to the first surface of the IC die, wherein the first wirelessly enabled functional block is coupled to the first surface of the IC die, and wherein the signal plane is coupled to the second surface of the IC die.

5. The IC device of claim 2, wherein the IC die comprises a via that electrically couples the signal plane to the first wirelessly enabled functional block.

6. The IC device of claim 2, wherein the signal plane is configured so as to have an opening to facilitate communication between the first wirelessly enabled functional block and the second wirelessly enabled functional block.

7. The IC device of claim 1, wherein at least one of the first wirelessly enabled functional block and the second wirelessly enabled functional block comprises a circuit trace or a metal island.

8. The IC device of claim 1, wherein at least one of the first wirelessly enabled functional block and the second wirelessly enabled functional block comprises an antenna.

9. The IC device of claim 8, wherein the antenna is a dipole antenna or a patch antenna.

10. The IC device of claim 1, wherein at least one of the first wirelessly enabled functional block and the second wirelessly enabled functional block comprises a transceiver.

11. The IC device of claim 10, further comprising a heat spreader coupled to the second surface of the IC die.

12. A method of manufacturing an integrated circuit (IC) device, comprising:
providing an IC die;
forming a first wirelessly enabled functional block on the IC die;
coupling the IC die to a substrate, wherein the first wirelessly enabled functional block is configured to wirelessly communicate with a second wirelessly enabled functional block coupled to the substrate.

13. The method of claim 12, wherein the forming the first wirelessly enabled functional block comprises forming a circuit trace.

14. The method of claim 12, wherein the forming the first wirelessly enabled functional block comprises coupling a transceiver to the IC die.

15. The method of claim 12, further comprising:
coupling a signal plane to the IC die.
